# EUROPÄISCHE PATENTSCHRIFT

(11) **EP 3 756 201 B1**
(45) Veröffentlichungstag und Bekanntmachung des Hinweises auf die Patenterteilung: **26.10.2022**
(21) Anmeldenummer: 19712995.0
(22) Anmeldetag: 21.03.2019
(51) Int. Cl.: H01F 27/06, H01F 27/32, H01F 30/04, H05K 1/02, H05K 3/34

(54) **NIEDERSPANNUNGSVERSORGUNGSTRANSFORMATOR FÜR SCHUTZKLEINSPANNUNGSANWENDUNGEN**
LOW-VOLTAGE SUPPLY TRANSFORMER FOR PROTECTIVE LOW-VOLTAGE APPLICATIONS
TRANSFORMATEUR D'ALIMENTATION BASSE TENSION POUR APPLICATIONS DE PROTECTION BASSE TENSION

(30) Priorität: 27.03.2018 DE 202018101697 U
(43) Veröffentlichungstag der Anmeldung: 30.12.2020
(73) Patentinhaber: Tridonic GmbH & Co. KG, 6851 Dornbirn (AT)
(72) Erfinder: LOCHMANN, Frank, 88147 Achberg (DE); PIOSKE, Jan, 6850 Dornbirn (AT); REBHANDL, Philip, 6850 Dornbirn (AT)
(74) Vertreter: Beder, Jens
(86) Internationale Anmeldenummer: PCT/EP2019/057146
(87) Internationale Veröffentlichungsnummer: WO 2019/185452

(56) Entgegenhaltungen:
- CN-A- 107 170 568
- JP-A- H0 864 411
- US-A1- 2007 075 812
- US-A1- 2013 321 114

## Beschreibung

Die Erfindung liegt auf dem Gebiet von Betriebsgeräten für Leuchtmittel sowie der elektrischen darin verbauten Transformatoren. Insbesondere werden ein Transformator, der für Schutzkleinspannungsanwendungen geeignet ist, sowie ein diesen Transformator verwendendes Betriebsgerät vorgeschlagen.

In Betriebsgeräten für Leuchtmittel werden für den Betrieb von Bauelementen wie zum Beispiel Mikrokontrollern, anwendungsspezifischen Schaltkreisen (abgekürzt ASICs), Schnittstellen zu externen Sensoren, sowie Mess- und Überwachungsschaltungen zahlreiche Kleinspannungen für die Spannungsversorgung der Bauelemente benötigt.

Eine bekannte Kleinspannungsversorgung (englisch: Low Voltage Power Supply, abgekürzt: LVPS) nutzt für die Erzeugung von drei unabhängigen Kleinspannungen, zum Beispiel 3.3 V, 6V und 12 V, einen Transformator mit einer Primärwicklung und mindestens drei Sekundärwicklungen.

Dabei gelten für eine Kleinspannungserzeugung unter den Randbedingungen der Schutzkleinspannung (SELV) enge Vorgaben hinsichtlich der Isolation entsprechender Schaltungsteile und spannungsführender Bauelemente voneinander. Diese Vorgaben hinsichtlich der elektrischen Isolation sind auch durch entsprechende Dimensionierung der Abstände von Anschlüssen des Transformators zu gewährleisten. Insbesondere zwischen Anschlüssen eines Transformators auf unterschiedlicher Seite einer SELV-Barriere, also Nicht SELV-Spannungen und - schaltungsteilen und SELV-Spannungen und -schaltungsteilen sind verschärfte Anforderungen hinsichtlich Abstand der Anschlüsse voneinander zu erfüllen.

Vergrößerte Abstände zwischen den Anschlüssen des Transformators bedeuten verlängerte Luftstrecken und Kriechstrecken und damit eine verbesserte elektrische Isolation der Anschlüsse zueinander.

Zugleich ist der verfügbare Raum für Bauelemente in dem Betriebsgerät begrenzt bzw. soll zur Reduzierung der Baugröße des Betriebsgeräts klein gehalten werden. Wickelgüter wie Spulen und insbesondere auch Transformatoren sind jedoch elektrische Bauelemente mit einem großen Raumbedarf.

US 2013/321114 A1 offenbart einen Transformator mit einem Spulenkörper, mindestens einer Primärwicklungsspule, mindestens eine Sekundärwicklungsspule und einer Magnetkernanordnung. Der Spulenkörper umfasst einen Hauptkörper, mehrere Verlängerungsstrukturen und mehrere Verbindungsstiftgruppen. Der Hauptkörper umfasst einen Kanal, mehrere Wicklungsabschnitte, einer ersten Verbindungsaufnahme und eine zweite Verbindungsaufnahme. Die mehreren Verlängerungsstrukturen sind mit der ersten Verbindungsaufnahme bzw. der zweiten Verbindungsaufnahme verbunden. Zusätzlich weist jede der mehreren Erweiterungsstrukturen eine Aussparung und eine abgestufte Struktur auf, wobei die abgestufte Struktur mehrere abgestufte Teile umfasst. Jede der Primärwicklungsspulen und der Sekundärwicklungsspulen umfasst mehrere Anschlüsse. Mehrere Anschlüsse der Sekundärwicklungsspule sind jeweils an den mehreren abgestuften Teilen der abgestuften Struktur angeordnet und an der Verbindungsstiftgruppe befestigt, die an einer der Verlängerungsstrukturen angeordnet ist.

CN 107170568 A zeigt einen Transformatorrahmen mit einer Wicklungsaufnahme mit Mittelbohrung, einer oberen Leitfläche und einer unteren Leitfläche, die sich jeweils entlang eines Endes der Wicklungsaufnahme erstrecken. Eine linke Positionierungsfläche und eine rechte Positionierungsfläche s5192ind beidseitig der an der oberen Leitfläche angeordnet. Die linke Positionierungsfläche hat eine rechteckige Form und erstreckt entlang der oberen Leitfläche vertikal nach oben.

Die rechte Positionierungsfläche hat eine V-förmige Struktur und ist entlang der oberen Leitfläche sich vertikal nach oben erstreckend angeordnet. Eine primärseitige Klemmenleiste und eine sekundärseitige Klemmenleiste sind beidseitig an der oberen Leitfläche angeordnet. Die Unterseite der primärseitigen Klemmenleiste und der sekundärseitigen Klemmenleiste weisen jeweils vertikal angeordnete leitfähige Klemmenstifte auf. Eine Breite der primärseitigen Klemmenleiste ist größer als die der sekundären Klemmenleiste, und die primärseitige Klemmenleiste ist mittig mit einem Durchgangsloch versehen. Der Transformatorrahmen stellt mittels unterschiedlicher linker und rechter Positionierungsflächen, mittels unterschiedlicher Breite der primärseitigen und sekundärseitigen Klemmenleiste, und dem mittig in der primärseitigen Klemmenleiste angeordneten Durchgangsloch, einer Fläche des Magnetkerns, einer Anzahl der Windungen und der Kriechstrecke werden in einem bestimmten Raumvolumen sichergestellt. Leistungsanforderungen können bei zugleich einfachem Aufbau eines Transformators mit dem Transformatorahmens erreicht werden.

JP H0864411 A offenbart einen Spulenkörper für einen Transformator, die einen ausreichenden Isolationsabstand gewährleisten kann. Ein vorstehender Verlängerungsabschnitt ist jeweils an beiden Enden eines unteren Randabschnitts des Spulenkörpers rechtwinklig zu einer Nut angeordnet, wobei der Spulenkörper aus einem röhrenförmigen Kern, einem oberen Randabschnitt und dem unteren Randabschnitt besteht. Der untere Randabschnitt ist in einer H-Form ausgebildet. An dem Verlängerungsabschnitt ist jeweils ein Vorsprung ausgebildet zum Führen eines Spulenendes angeordnet. Mehrere Anschlussstifte sind jeweils an dem Verlängerungsabschnitt vorgesehen. Das Spulenende ist an einer Außenseite des Vorsprungs, die jeweiligen Anschlussstifte umschlingend, angeordnet.

Die Einführung einer dritten, zusätzlichen Kleinspannung wie oben beschrieben, möglicherweise unter Berücksichtigung verschärfter Anforderungen nach SELV, in einem Betriebsgerät führt zu größeren Abmessungen des Transformators, um die Abstände zwischen den einzelnen Anschlüssen der einzelnen Wicklungen sicherstellen zu können. Mit der Einführung zusätzlicher Sensoren, Schnittstellen und Funktionalitäten des Betriebsgeräts wird aber gerade eine solche zusätzliche Kleinspannung nötig, um zusätzliche Bauelemente wie Mikroprozessoren und Schaltungsteile mit Energie zu versorgen.

Es ist daher die Aufgabe zu lösen, Transformatoren für Kleinspannungsanwendungen mit möglichst geringen Abmessungen zu schaffen.

Ein Betriebsgerät nach Anspruch 1, umfassend einen Transformator und eine Leiterplatte lösen die vorstehende Aufgabe.

Die Unteransprüche definieren weitere vorteilhafte Ausführungen der Erfindung.

Der Transformator des Betriebsgeräts weist eine primärseitige Wicklung und zumindest eine sekundärseitige Wicklung auf, die auf einem (gemeinsamen) Spulenkörper angeordnet sind. Der Spulenkörper umfasst einen Basisabschnitt und kann insbesondere einstückig mit dem Basisabschnitt ausgeführt sein. In dem Basisabschnitt sind ein erstes elektrisches Anschlusselement, das mit der ersten Wicklung elektrisch verbunden ist, und ein zweites elektrisches Anschlusselement, das mit der zumindest einen zweiten Wicklung verbunden ist, angeordnet. Der Basisabschnitt des Spulenkörpers weist zwischen dem ersten elektrischen Anschlusselement und dem zweiten elektrischen Anschlusselement eine Ausnehmung auf. Das Betriebsgerät einen Transformator nach einer der vorstehenden Ausführungen auf einer Leitplatte anordnet. Die Leiterplatte weist dabei eine zu der Ausnehmung in dem Basisabschnitt des Spulenkörpers korrespondierende Aussparung (Schlitz) auf.

Korrespondierend bedeutet dabei, dass die Längserstreckung der Aussparungen in dieselbe Richtung verlaufen und vorzugsweise die Dimensionen der beiden Schlitze, also Breite und Länge, gleich sind.

Durch die Anordnung der Ausnehmung, insbesondere ausgeführt als Schlitz, zwischen dem ersten Anschlusselement und dem zweiten Anschlusselement wird eine Kriechstrecke entlang des Basisabschnitts des Spulenkörpers zwischen dem ersten Anschlusselement und dem zweiten Anschlusselement verändert und zwar insbesondere verlängert.

Als Kriechstrecke wird allgemein die kürzeste Entfernung entlang einer Oberfläche eines festen elektrisch isolierenden Materials zwischen zwei leitenden Elementen bezeichnet. Problematisch beim Verringern von Bauteilgrößen ist dabei insbesondere, dass nicht nur die Pins (Anschlusselemente) eines Bauteils, wie hier des Transformators, sondern auch Lötstellen berücksichtigt werden müssen.

Im vorliegenden Fall verläuft die Kriechstrecke zwischen dem ersten Anschluss und dem zweiten Anschluss entlang einer Oberfläche des Spulenkörpers, und zwar des Basisabschnitts des Spulenkörpers, in dem die elektrischen Anschlusselemente angeordnet bzw. befestigt sind. Die elektrischen Anschlusselemente können beispielsweise als Kontaktpins aus einer Grundfläche des Basiselements herausragen oder als Kontaktflächen in die Grundfläche des Spulenkörpers eingelassen sein.

Eine kürzeste (minimale) Kriechstrecke ohne die Ausnehmung würde entlang der Grundfläche des Spulenkörpers auf der Verbindungslinie zwischen dem ersten Anschlusselement und dem zweiten Anschlusselement des Spulenkörpers bzw. der dort vorhandenen Lötstellen verlaufen. Die kürzeste Kriechstrecke mit der erfindungsgemäß angeordneten Ausnehmung verläuft hingegen entlang der Oberfläche des Basiselements des Spulenkörpers nicht auf der direkten Verbindungslinie des Spulenkörpers zwischen dem ersten Anschlusselement und dem zweiten Anschlusselement, sondern führt um die Ausnehmung des Spulenkörpers herum. Damit ist mit der erfindungsgemäß angeordneten Ausnehmung eine minimale Länge der Kriechstrecke, die länger ist als eine theoretische Kriechstrecke entlang einer direkten Verbindungslinie zwischen dem ersten Anschlusselement und dem zweiten Anschlusselement ohne die Ausnehmung, zu realisieren.

Insbesondere ist es vorteilhaft, wenn in dem Transformator die Ausnehmung derart ausgebildet ist, dass Ausdehnungen der Ausnehmung eine minimale Kriechstrecke zwischen dem ersten elektrischen Anschluss der ersten Wicklung und dem zweiten elektrischen Anschluss der zweiten Wicklung gewährleisten.

Damit wird die basierend auf den einschlägigen Normen geforderte minimale Kriechstrecke mit wirtschaftlichem Aufwand sichergestellt und zugleich lediglich eine geringe Beeinträchtigung der Stabilität des Spulenkörpers durch schlitzen seines Basiskörpers bewirkt. Die Kriechstrecke wird beispielsweise durch Fräsen oder in einem additiven Fertigungsverfahren des Spulenkörpers realisiert. Somit ist der Materialabtrag für die Herstellung der Ausnehmung ebenfalls minimiert.

Ein vorteilhafter Betriebsgerät mit Transformator zeichnet sich dadurch aus, dass die Ausdehnung der Ausnehmung in einer Richtung senkrecht zu einer direkten Verbindungslinie zwischen dem ersten elektrischen Anschlusselement und dem zweiten elektrischen Anschlusselement größer als die Abmessungen in Richtung der Verbindungslinie sind, wobei die Ausdehnung ab der Verbindungslinie gemessen wird.

Damit wird eine deutliche Verlängerung der Kriechstrecke erreicht, ohne dass der Materialabtrag groß und damit die Bearbeitungszeit lang wird. Zugleich ist die Herstellung mittels Fräsen und/oder Sägen des Spulenkörpers einfach zu bewirken.

Ein Transformator nach einer weiteren Ausführung des Betriebsgeräts zeichnet sich dadurch aus, dass der Transformator eine erste sekundärseitige Wicklung als erste Wicklung, eine zweite sekundärseitige Wicklung als zweite Wicklung und zumindest eine weitere, dritte sekundärseitige Wicklung aufweist. Damit werden Spannungen insbesondere für eine Leistungsmessvorrichtung des Betriebsgeräts, eine Schnittstelle und einen Mikroprozessor des Betriebsgeräts erzeugt. Die Schnittstelle ist dabei insbesondere galvanisch von den anderen Elementen getrennt.

Insbesondere bei zahlreichen sekundärseitigen Wicklungen des Transformators tritt das Problem auf, dass die Abstände zwischen Kontaktelementen (Pins) des Transformators zu gering werden, um eine normengerechte Isolation sicherzustellen, ohne die Abmessungen des Transformators zu vergrößern.

Ein Transformator eines vorteilhaften Ausführungsbeispiels des Betriebsgeräts zeichnet sich dadurch aus, dass die erste sekundärseitige Wicklung und der erste elektrische Anschluss die Anforderung zur Erzeugung einer Sicherheitskleinspannung erfüllen.

Transformatoren zur Erzeugung von Sicherheitskleinspannungen (englisch Safety Extra Low Voltage, abgekürzt SELV) müssen derart ausgelegt werden, dass ein Kurzschluss zwischen Wicklungen mit möglicherweise hohen Spannungswerten und der Sekundärwicklung sowie deren jeweiligen Anschlüssen nicht möglich ist. Die Auslegung erfordert auch größere Kriechstrecken und ist daher für eine hohe Anzahl von Sekundärwicklungen für eine entsprechend hohe Anzahl an Versorgungsspannungen nur schwierig bei zugleich geringen Transformatorabmessungen zu verwirklichen. Die erfindungsgemäße Ausnehmung und die damit bewirkte Verlängerung der Kriechstrecke(n) ist daher insbesondere für eine Mehrzahl von Sekundärwicklungen besonders vorteilhaft.

Ein vorteilhaftes Betriebsgerät mit einem Transformator angeordnet auf einer Leiterplatte ist derart eingerichtet, dass die erste sekundärseitige Wicklung für die Erzeugung einer ersten Versorgungsspannung, die zweite sekundärseitige Wicklung für die Erzeugung einer zweiten Versorgungsspannung und die dritte sekundärseitige Wicklung für die Erzeugung einer dritten Versorgungsspannung genutzt wird.

Das Betriebsgerät nach einem vorteilhaften Ausführungsbeispiel ist dadurch ausgezeichnet, dass der Transformator unmittelbar an einem Rand der Leiterplatte auf der Leiterplatte angeordnet ist. Damit kann die Aussparung zum Rand der Leiterplatte hin offen sein, was eine Fertigung vereinfacht. Insbesondere kann sich auch die Positionierung des Transformators an den beiden Aussparungen orientieren, wobei eine Positionierhilfe hierzu von außen eingesetzt werden kann.

Außerdem wird damit erreicht, dass lediglich eine Ausnehmung mit einer geringen Fläche und vorteilhaft kleinen Abmessungen ausreicht, um eine längere Kriechstrecke auf der Oberfläche und Unterseite der Leiterplatte zu bewirken.

Die Anordnung eines bevorzugten Ausführungsbeispiels zeichnet sich dadurch aus, dass die Aussparung der Leiterplatte unmittelbar (direkt) an einem Umfang der der Leiterplatte angeordnet ist.

Wenn die Aussparung der Leitplatte direkt an deren Umfang angeordnet ist, ist eine einfache, mittels Fräsen oder Sägen der Leiterplatte herzustellende Aussparung zu verwirklichen. Zugleich kann eine Fläche der Aussparung geringer ausfallen, um eine bestimmte Verlängerung der Kriechstrecke auf der Leiterplatte zu erreichen, als dies bei Anordnung der Aussparung innerhalb der Leiterplatte und fern von deren Umfang der Fall wäre. Damit ist die Herstellung der Aussparung besonders wirtschaftlich hinsichtlich Materialverlust bei der Fertigung für eine geforderte minimale Länge der Kriechstrecke.

Das Betriebsgerät kann insbesondere für den Einsatz in Leuchten ausgelegt mit LED Leuchtmitteln sein.

Insbesondere Betriebsgeräte für Gebäudetechniksysteme für Leuchten weisen zunehmend mehr Funktionalitäten und Kommunikationsschnittstellen auf, die mehrere unterschiedliche Versorgungsspannungen in den Betriebsgeräten erfordern. Zugleich bestehen beispielsweise für Betriebsgeräte für Leuchtmittel, wie zum Beispiel LEDs, verschärfte Anforderungen hinsichtlich SELV und Potentialbarrieren. Damit ist die Erfindung bei Betriebsgeräten für Beleuchtungsanwendungen mit nur geringem verfügbarem Bauraum besonders nutzbringend anwendbar.

Ausführungen der Erfindung werden anhand der Figuren näher erläutert, bei denen
- Figur 1: in einer Ansicht eine Ausführung des erfindungsgemäßen Transformators auf einer Leiterplatte,
- Figur 2: schematische Ansichten eines Ausführungsbeispiels des Transformators,
- Figur 3A, 3B: Ansichten einer Ausführung des erfindungsgemäßen Transformators auf einer Leitplatte, sowie
- Figur 4: eine schematische Schaltskizze einer Niederspannungsvesorgung für ein Betriebsgerät unter Nutzung eines erfindungsgemäßen Transformators zeigt.

Elektrische Transformatoren werden in elektronischen Schaltungen zur Spannungswandlung, insbesondere in Netzteilen zur Bereitstellung von Kleinspannungen genutzt. Weiterhin werden sie bei der Signalübertragung und der Schutztrennung verwendet.

Die Grundlage für die Bestimmung einer Kriechstrecke ist der Effektivwert der an dieser Kriechstrecke liegenden Dauerspannung, die je nach Anwendungsfall Arbeitsspannung, Bemessungs-Isolationsspannung oder Bemessungsspannung genannt wird.

Der erfindungsgemäße Transformator hat statt nur einer einzelnen mehrere (mindestens zwei) getrennte Sekundärwicklungen für unterschiedliche Spannungen oder für getrennte Stromkreise haben. Dabei ist eine Sekundärwicklung für die Energieversorgung einer jenseits einer SELV-Barriere angeordneten Schnittstelle eines Betriebsgeräts vorgesehen.

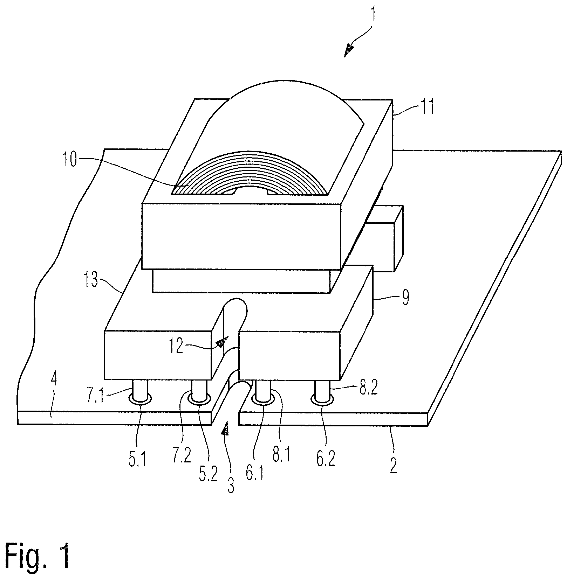

In Figur 1 ist eine vereinfachte Ansicht eine Ausführung des erfindungsgemäßen Transformators 1 auf einer Leiterplatte 2 angeordnet gezeigt.

Die Leiterplatte 2 umfasst eine obere Seite der Leiterplatte 2 auf der Bauelemente wie der Transformator 2 bestückt werden. Auf einer unteren Seite der Leiterplatte 2 können Leiterbahnen angeordnet sein, die eine Verschaltung der Bauelemente der mit der Baugruppe realisierten Schaltung verwirklichen.

Der dargestellte einlagige Aufbau dient lediglich zur Wiedergabe des prinzipiellen Aufbaus, ebenso ist die Erfindung für mehrlagige Leiterplatten, doppelseitige Bestückung und für oberflächenmontierte Bauelemente (abgekürzt: SMD) vorteilhaft zu nutzen.

Der Transformator 1 ist dabei auf einer ersten, oberen Seite der Leiterplatte 2 und in unmittelbarer Nähe einer Randfläche der Leiterplatte 2 angeordnet. Die Randfläche 4 umrandet die Leiterplatte 2.

Die Leiterplatte 2 weist eine Aussparung 3 auf, die sich bevorzugt ausgehend von der Randfläche 4 von einem Randbereich der Leiterplatte 2 in Richtung auf den inneren Bereich der Leiterplatte 2 hin erstreckt.

Die Aussparung 3 ist in Figur 1 mit einer im Wesentlichen rechteckigen Grundfläche in der Ebene der Oberseite und der Unterseite der Leiterplatte 2 dargestellt. Diese im Wesentlichen rechteckige Grundform ergibt sich in vorteilhafter Weise mittels Ausfräsen oder Sägen der Leitplatte 2 zur Erstellung der Aussparung 3. Die Aussparung 3 ist somit als zum Rand der Leiterplatte 2 hin offener Schlitz ausgeführt.

Die im Wesentlichen rechteckige Grundfläche der Aussparung 3 zeigt gerade Begrenzungslinien der Aussparung 3 mit der Oberseite und der Unterseite der Leiterplatte 2. Ebenso sind andere Linienformen, zum Beispiel eine Wellenlinie denkbar. Die Grundfläche der Aussparung 3 kann ebenso eine andere Form als ein Rechteck aufweisen, beispielsweise ein Trapez oder eine T-Form.

Die Aussparung 3 ist ebenso mittels anderer Fertigungsverfahren als Sägen oder Fräsen herstellbar. Beispielsweise kann die Aussparung 3 im Rahmen der Herstellung der Leiterplatte 2 mit einem additiven Fertigungsverfahren, zum Beispiel 3D-Druck, gefertigt werden.

Die Leiterplatte 2 weist darüber hinaus an ihrer Oberseite und/oder der Unterseite Kontaktelemente zur Kontaktierung von Bauelementen auf. In Figur 1 sind erste Kontaktelemente 6.1, 6.2 und zweite Kontaktelemente 5.1, 5.2 dargestellt. Die ersten Kontaktelemente 6.1, 6.2 ermöglichen die elektrische Kontaktierung von ersten elektrischen Anschlusselementen 8.1, 8.2 des Transformators 1. Die zweiten Kontaktelemente 5.1, 5.2 ermöglichen die elektrische Kontaktierung von zweiten elektrischen Anschlusselementen 7.1, 7.2 des Transformators 1. Die ersten und zweiten elektrischen Anschlusselemente 7.1, 7.2 und 8.1, 8.2 können zum Beispiel Kontaktpins oder elektrisch leitende Kontaktflächen des Transformators 1 sein.

Die Kontaktelemente 5.1, 5.2, 6.1, 6.2 auf Seite der Leiterplatte 2 können beispielsweise metallisierte Flächen auf der Leiterplatte 2 oder Lötpads sein. Die Kontaktelemente 5.1, 5.2, 6.1, 6.2 können Bohrungen zum Durchführen von Kontaktstiften (Kontaktpins) des Transformators 2 umfassen, so dass ein Verlöten auf der Rückseite der Leiterplatte 2 erfolgt.

Der Transformator 1 umfasst einen Spulenkörper 9 mit einem Basisabschnitt 13. Der Basisabschnitt 13 ist bei einem auf der Leiterplatte 2 bestückten Transformator 1 der Leiterplatte 2 zugewandt. Der Basisabschnitt 31 kann Stützmittel zum Abstützen auf der Leiterplatte 2 aufweisen.

Der Spulenkörper 9 umfasst neben dem Basisabschnitt 13 weiter eine oder mehrere Wickelkammern zur Aufnahme der Wicklungen des Transformators 1.

Die ersten Anschlusselemente 8.1, 8.2 und die zweiten Anschlusselemente 7.1, 7.2 stehen an einer der Leiterplatte 2 zugewandten Seite des Basisabschnitts 13 des Spulenkörpers 9 hervor und dienen dem Anschluss des auf der Leiterplatte 2 montierten Transformators 1.

Die ersten Anschlusselemente 8.1, 8.2 sind mit einer ersten Wicklung des Transformators 1 elektrisch verbunden. Die zweiten Anschlusselemente 7.1, 7.2 sind mit einer zweiten Wicklung des Transformators 1 elektrisch verbunden.

Die erste Wicklung und die zweite Wicklung können, müssen jedoch nicht, sekundärseitige Wicklungen des Transformators 1 sein.

Der Transformator 1 kann weitere Wicklungen umfassen, die als ein Wicklungspaket 10 oder in mehreren getrennten Wicklungspaketen auf einem Spulenkörper 9 in bekannter Weise gewickelt sind.

Der Spulenkörper 9 (englisch: Bobbin) gewährleistet, die Wicklungen in der passenden Form herzustellen und bietet zusätzliche Isolation zu einem Kern 11. Der Spulenkörper 9 kann mittels Kunststoffspritzguss hergestellt werden. Der Spulenkörper 9 kann eingespritzte Kontaktstifte als Anschlusselemente 7.1, 7.2, 8.1, 8.2 besitzen und/oder Führungen für ein- und auslaufende Wicklungsenden der Wicklungen. Damit wird auf einer automatischen Wickelmaschine eine geordnete Wicklung des Transformators 1 ermöglicht.

An dem Spulenkörper 9 ist weiter der Kern 11 (Transformatorkern, Magnetkern) angeordnet und festgelegt, der aus einem ferromagnetischen Material besteht. Der ferromagnetische (Eisen-) Kern 11 schließt einen magnetischen Kreis und ist ohne beabsichtigte Einschränkung in Fig. 1 als E-förmiger Magnetkern angenommen. Optional kann der Transformator 2 auch ohne Kern 11 ausgeführt sein.

Der erfindungsgemäße Spulenkörper 9 weist in seinem Basisabschnitt 13 eine Ausnehmung 12 auf. Der Basisabschnitt 13 weist eine ebene untere Fläche auf, die der Leiterplatte 2 zugewandt ist, wenn der Transformator 1 auf der Leiterplatte 2 montiert ist.

Die Ausnehmung 12 weist im Wesentlichen dieselbe Grundfläche und Form wie die Aussparung 3 der Leiterplatte 2 auf. Daher gilt für die Grundform der Ausnehmung 12 das für die Aussparung 3 Gesagte in entsprechender Weise.

Wenn der Transformator 1 auf der Leiterplatte 2 montiert ist, kommen die Aussparung 3 und die Ausnehmung 12 unmittelbar übereinander und mit derselben Orientierung zu liegen.

Damit wird eine minimale Kriechstrecke zwischen dem ersten Anschlusselement 8.1 und dem zweiten Anschlusselement 7.2 des Transformators 1 auf der Oberfläche des Spulenkörpers 9 verlängert. Ebenso wird eine minimale Kriechstrecke zwischen dem dem ersten Anschlusselement 8.1 zugeordneten Kontaktelement 6.1 und dem zweiten Anschlusselement 7.2 zugeordneten zweiten Kontaktelement 5.2 auf einer Oberseite und/oder einer Unterseite der Leiterplatte 2 verlängert.

Die Aussparung 3 und die Ausnehmung 12 ermöglichen aufgrund der verlängerten Kriechstrecken mehr Anschlusselemente 7.1, 7.2, 8.1, 8.2 und damit auch mehr Wicklungen des Transformators 1 auf begrenztem Raum anzuordnen, insbesondere Anschlusselemente von Wicklungen, die Energieverbrauchern auf unterschiedlichen Seiten einer SELV-Barriere zuzuordnen sind.

Dies ermöglichen die Aussparung 3 und die Ausnehmung 12 ohne Veränderung der Geometrie der der Anschlusselemente 7.1, 7.2, 8.1, 8.2 des Transformators 1, da höhere Anforderungen hinsichtlich der Isolation einzelner oder bei entsprechender Anordnung, mehrerer Anschlusselemente 7.1, 7.2, 8.1, 8.2 erfüllt werden.

Die Möglichkeiten und verfügbaren Freiheitsgrade des Entwicklungsingenieurs werden damit in vorteilhafter Weise vergrößert. Beispielsweise lassen sich mit einem einheitlichen Aufbau des Transformators 1 unterschiedliche Vorschriften unterschiedlicher regulatorischer Gebiete erfüllen.

Zugleich sind verbesserte Isolationseigenschaften hinsichtlich der Kriechstrecken bei unverändert geringem Raumbedarf des Transformators 1 zu erfüllen.

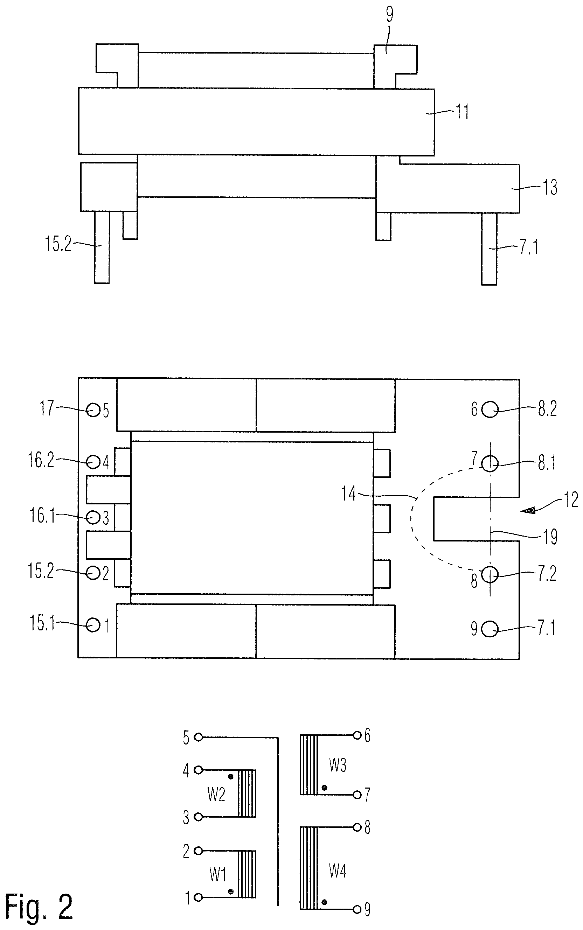

Figur 2 zeigt schematische Ansichten eines Ausführungsbeispiels des Transformators 1. Dabei gibt die obere Darstellung der Figur 2 eine Seitenansicht des Transformators 1 wieder, in der der Grundkörper 13 des Spulenkörpers 9 samt Basisabschnitt 13 und davon hervorstehende Anschlusselementen 7.1 sowie 15.2, sowie der magnetische Kern 11 zu erkennen sind. Aus der unteren Oberfläche des Spulenkörpers 9 bzw. dessen Basisabschnitts 13 sind sichtbar die Anschlusselemente 15.1, 5.1 herausgeführt.

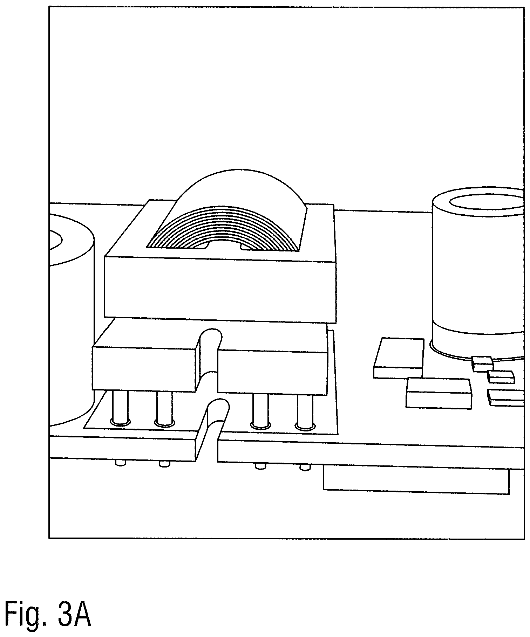

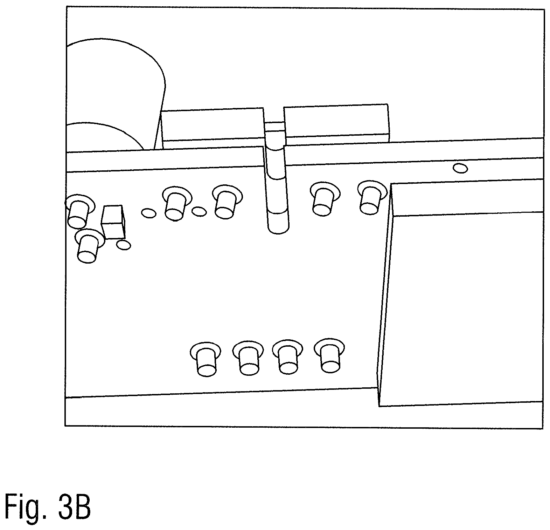

Das zweite Anschlusselement 7.1 der zweiten Wicklung (W4) verdeckt in der oberen Darstellung der Figur 3 das weitere Anschlusselement 7.2 der zweiten Wicklung W4 und die Anschlusselemente 8.1 und 8.2 der ersten Wicklung W3. Die Lage der ersten und zweiten Anschlusselemente 7.1, 7.2, 8.1, 8.2 auf einer geraden Linie lässt sich insbesondere in der mittleren Darstellung der Figur 3 erkennen. Die mittlere Darstellung der Figur 3 zeigt den Transformator 1 in einer Draufsicht, in der die Lage sämtlicher Anschlusselemente verdeutlicht ist. Zwischen dem ersten Anschlusselement 8.1 der ersten Wicklung W3 und dem unmittelbar benachbarten zweiten Anschlusselement 7.2 der zweiten Wicklung W4 ist die Ausnehmung 12 angeordnet.

Aus der mittleren Darstellung der Figur 2 wird insbesondere deutlich, dass die Lage und die räumliche Ausbildung der Ausnehmung 12 eine Kriechstrecke 14 auf der der Leiterplatte 2 zugewandten Fläche des Spulenkörpers 9 beziehungsweise dessen Basisabschnitts 13 zwischen dem ersten Anschlusselement 8.1 der Wicklung W3 und dem zweiten Anschlusselement 7.2 der Wicklung W4 bestimmt. Damit werden die durch die Länge der Kriechstrecke 14 bestimmten Isolationseigenschaften zwischen dem ersten und dem zweiten Anschlusselementen 7.2 und 8.1 durch die Anordnung und die Grundfläche der Ausnehmung 12 mitbestimmt. Da das jeweils andere erste bzw. zweite Anschlusselement ohnehin erheblich weiter entfernt liegen, ist hier die Kriechstrecke automatisch länger.

In der mittleren Darstellung der Figur 2 sind außerdem Anschlusselemente 15.1, 15 2 zur Kontaktierung der Wicklung W1, Anschlusselemente 16.1, 16.2 zur Kontaktierung der Wicklung W2 und ein Anschlusselement 17 zur Kontaktierung einer Kupferfolie als Schirm (Schirmwicklung) gezeigt. Die Anordnung der Anschlusselemente 15.1, 15 2, 16.1, 16.2 und 17 entlang einer geraden Linie entspricht einer bekannten Anordnung von Anschlusselementen.

Der Transformator 1 kann eine Schirmwicklung aufweisen, wenn ein Ableitstrom unterbunden werden soll, der ohne Schirm von der Primärseite des Transformators 2 zur Sekundärseite des Transformators infolge kapazitive Kopplung der Wicklungen gelangt. Diese Schirmwicklung ist an Masse angeschlossen und dient zur Verringerung der kapazitiven Kopplung zwischen primärseitiger Wicklung und einer oder mehrerer sekundärseitiger Wicklungen. Der Schirm kann mittels einer einlagigen Drahtwicklung oder mittels Folie aus einem leitfähigen Material verwirklicht werden, die nur an einem Ende angeschlossen ist. Durch den Schirm wird der Übergang von hochfrequenten Störungen von der Primärseite zur Sekundärseite des Transformators gedämpft.

Die untere Darstellung der Figur 2 gibt schematisch die schaltungstechnische Zuordnung der Anschlusselemente 15.1, 15.2 zu der primärseitigen Wicklung W1, der ersten Anschlusselemente 8.1, 8.2 zu der sekundärseitigen ersten Wicklung W3, der zweiten Anschlusselemente 7.1, 7.2 zu der sekundärseitigen zweiten Wicklung W4 und der weiteren Anschlusselemente 16.1, 16.2 zu der sekundärseitigen Wicklung W2 des Transformators 2 wieder.

Figur 3A zeigt eine perspektivische Ansicht einer Ausführung des erfindungsgemäßen Transformators 1 angeordnet auf einer Leiterplatte 2 eines Betriebsgeräts. Die Figur 3A zeigt die Anordnung des Transformators 2 in der unmittelbaren Nähe des Rands 4 der Leiterplatte 2. Deutlich zu erkennen ist, dass die Ausnehmung 12 und die Aussparung 3 zueinander korrespondierend hinsichtlich Form, Orientierung und Lage angeordnet sind, wenn der Transformator 1 auf der Leiterplatte 2 montiert ist.

Korrespondierende Anordnung ist in diesem Zusammenhang so zu verstehen, dass die jeweilige Grundfläche der Ausnehmung 12 und der Aussparung 3 in der Ebene der Oberseite bzw. der Unterseite der Leiterplatte 2 im Wesentlichen übereinstimmen, wenn die Grundfläche aus einer Richtung einer Flächennormalen der Oberseite bzw. der Unterseite der Leiterplatte betrachtet wird und der Transformator 1 auf der Leiterplatte 2 montiert ("bestückt") ist.

Figur 3B zeigt eine zweite perspektivische Ansicht, die zugleich die Unterseite der Leiterplatte 2 sichtbar macht. Aus der Figur 3B wird deutlich, dass eine Kontaktierung der ersten und zweiten Anschlusselemente 7.2 und 8.1 auf den ersten und zweiten Kontaktelementen 5.2, 6.1 eine theoretische Kriechstrecke 19 zwischen den ersten und zweiten Kontaktelementen 5.2 und 6.2 auf der unteren Seite der Leiterplatte 2 mittels Lötpunkten die theoretische Kriechstrecke 19 zwischen den ersten und zweiten Kontaktelemente 5.2, 6.1 verringern würde, wenn die Aussparung 3 nicht in die Leiterplatte 2 eingebracht wäre.

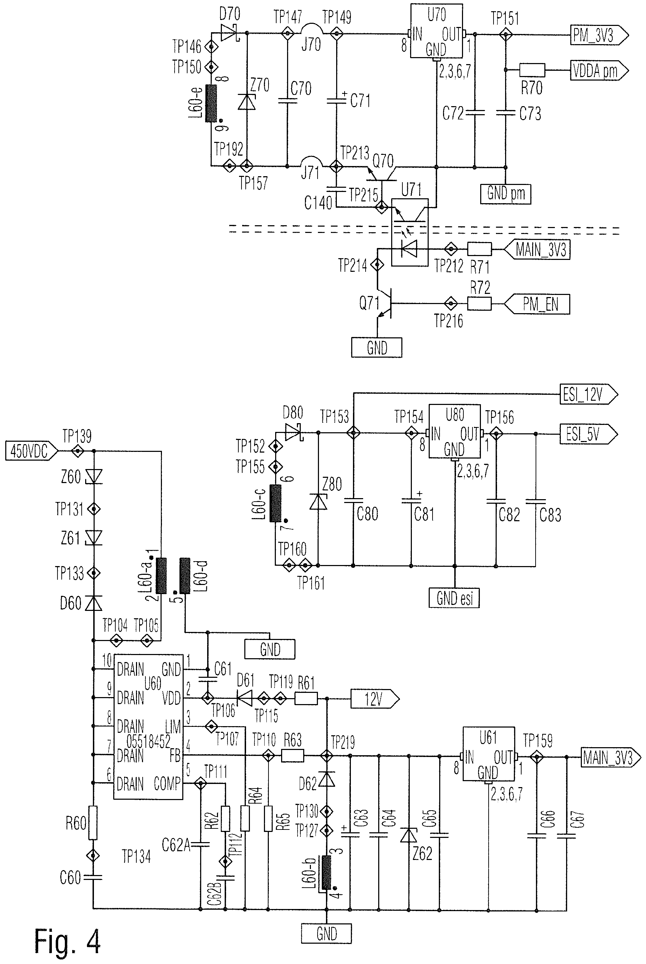

Figur 4 zeigt eine Schaltskizze einer Niederspannungsvesorgung für ein Betriebsgerät unter Nutzung eines erfindungsgemäßen Transformators 1.

Der Aufbau des Betriebsgeräts unter Nutzung der Erfindung unterscheidet sich grundsätzlich nicht von den bekannten Betriebsgeräten für Leuchtmittel, beispielsweise für Leuchtdioden (LEDs). Eine Netzeingangsspannung, beispielsweise eine Netzwechselspannung in einem Spannungsbereich von 120 bis 250 VAC versorgt das Betriebsgerät. Die Netzeingangsspannung wird über bekannte Baugruppen und Schaltkreise, wie zum Beispiel ein EMI Filter und eine Leistungsfaktorkorrekturschaltung zur Korrektur des Leistungsfaktors in eine Busspannung umgesetzt. Diese Busspannung ist die Eingangsspannung für eine Schaltung zur Niedervoltspannungserzeugung (Niedervoltspannungsversorgung 18) des Betriebsgeräts.

Die Niedervoltspannungsversorgung 18 des Betriebsgeräts erzeugt die zur Versorgung der verschiedenen Schaltungen und Bauelemente des Betriebsgeräts notwendigen Versorgungsspannungen, insbesondere auch Schutzkleinspannungen.

Beispielsweise kann das Betriebsgerät einen oder mehrere Mikroprozessoren, einen oder mehrere ASICs, Optokoppler, und Schnittstellenbaugruppen für Schnittstellen zu extern angeordneten Sensoren umfassen.

Insbesondere kann durch die Kleinspannungsversorgung 18 auch eine Versorgungsspannung für externe Sensoren erzeugt werden. Diese Versorgungsspannungen für externe Sensoren können über SELV-Barrieren geführt werden. Damit unterliegen alle über eine SELV Barriere hinweg auf einem elektrischen Potential liegenden Schaltungsteile erhöhten Anforderungen an Potentialtrennung und werden unter besonderer Beachtung der für Schutzkleinspannungen geltenden Vorschriften ausgeführt.

Die Niederspannungsversorgung 18 wird eingangsseitig von der Busspannung von einem Ausgang der Leistungsfaktorkorrekturschaltung gespeist.

Die Niederspannungsversorgung 18 erzeugt aus der Busspannung die für die Versorgung der verschiedenen Schaltkreise und Bauelemente notwendigen Versorgungsspannungen. Dabei nutzt die Niederspannungsversorgung den Transformator 1, um im dargestellten Beispiel drei unabhängige und voneinander isolierte Kleinspannungen bereitzustellen.

Die primärseitige Wicklung W1 des Transformators 1 wird von der Busspannung gespeist. Die wechselnde Busspannung bewirkt einen wechselnden magnetischen Fluss in dem Kern 11 des Transformators 1.

Der Transformator 1 stellt über eine Mehrzahl sekundärseitiger Wicklungen (Lastseite), in denen durch den wechselnden magnetischen Fluss jeweils eine elektrische Spannung induziert wird, sekundärseitige Ausgangspannungen bereit.

Über die sekundärseitige Wicklung W4 des Transformators wird im dargestellten Beispiel eine erste Versorgungsspannung U_{V1} erzeugt. Die erste Versorgungsspannung U_{V1} kann zum Beispiel für die Spannungsversorgung einer Leistungsmessungsschaltung mit einem Spannungswert von +6V genutzt werden.

In Figur 4 ist gezeigt, die erste Versorgungsspannung U_{V1} mittels eines Linearreglers U70 zu stabilisieren. Die erste Versorgungsspannung U_{V1} ist über einen Optokoppler U71 und einen Transistor Q70 an- und ausschaltbar ausgelegt. Die Ansteuerung des Optokopplers U71 zum An- und Ausschalten der ersten Versorgungsspannung U_{V1} erfolgt mittels eines Schaltsignals PM_EN, das beispielsweise von einem ASIC oder einem Mikrokontroller des Betriebsgeräts ausgegeben wird.

Für den Betrieb des Optokopplers U71 ist eine zweite Versorgungsspannung U_{V2} erforderlich, die über eine sekundärseitige Wicklung W2 mittels eines weiteren diskreten Linearreglers U61 erzeugt wird. Die zweite Versorgungsspannung U_{V2} ist im dargestellten Beispiel mit einem Spannungswert von 3.3 V angenommen.

Für den Betrieb eines ASIC ist eine dritte Versorgungsspannung U_{V3} erforderlich, die über die sekundärseitige Wicklung W4 erzeugt wird. Die dritte Versorgungsspannung U_{V3} ist im dargestellten Beispiel mit einem Spannungswert von 12 V angenommen. Der ASIC wird mit der dritten Versorgungsspannung U_{V3} gespeist und kann selbst dazu ausgelegt sein, eine weitere, vierte Versorgungsspannung U_{V4} mit 3.3 V für einen Mikrokontroller ausgehend von der dritten Versorgungsspannung U_{V3} mittels einer internen Spannungsversorgung des ASIC zu erzeugen und an den Mikrokontroller auszugeben.

Eine fünfte Versorgungsspannung U_{V5} wird mittels der sekundärseitigen Wicklung W3 für einen externen Sensor und/oder eine externe Schnittstelle des Betriebsgeräts erzeugt. Die fünfte Versorgungsspannung U_{V5} ist in Figur 4 für einen Versorgungspannungsbereich von 12 bis 18 V ausgelegt.

Die Niederspannungsversorgung 18 erzeugt aus der fünften Versorgungsspannung U_{V5} mittels noch eines weiteren Linearreglers U80 eine sechste Versorgungsspannung U_{V6} in Höhe von 5 V aus der fünften Versorgungsspannung U_{V5}. Die sechste Versorgungsspannung U_{V6} dient der Versorgung der Schnittstellenbaugruppe für die Bereitstellung einer Schnittstelle nach extern des Betriebsgeräts.

Der externe Sensor ist im vorliegenden Beispiel über eine Potentialbarriere (SELV Barriere) von der Niederspannungsversorgung 18 getrennt. Da die sechste Versorgungsspannung U_{V6} als Kleinspannung über die Potentialbarriere geführt ist, sind hinsichtlich der Anschlusselemente der Wicklung W3 des Transformators 1 erhöhte Anforderungen hinsichtlich der Isolation zu den Anschlusselementen der Wicklungen W1, W2, und W4 des Transformators 1 zu erfüllen. Insbesondere ist eine Kriechstrecke 14 zwischen den Leitungen und Kontakten der Anschlusselemente der Wicklung W3 des Transformators einerseits und den Anschlusselementen der Wicklung des Transformators W1, W2, und W4 mit einer größeren Länge der Kriechstrecke 14 sicherzustellen, als dies für eine jeweilige Kriechstrecke 14 zwischen den Anschlusselementen der Wicklungen W1, W2, und W4 gilt.

Dies wird erfindungsgemäß wie vorstehend ausführlich so gelöst, dass die Kriechstrecke 14 zwischen dem ersten Anschlusselement 8.1 der ersten Wicklung W3 und dem unmittelbar benachbarten Anschlusselement 7.2 der zweiten Wicklung W4 mittels der Ausnehmung 12 des Spulenkörpers 9 die Kriechstrecke 14 verlängert wird. Damit wird die Kriechstrecke 14 zwischen dem ersten Anschlusselement 8.1 der ersten Wicklung W3 und dem unmittelbar benachbarten zweiten Anschlusselement 7.2 der zweiten Wicklung W4 an dem Spulenkörper 9 an der, der Leitplatte 2 zugeordneten Fläche des Transformators 1 verlängert, um die elektrische Isolation sicherzustellen.

Ebenso wird auf der Leiterplatte 2 die korrespondierende Kriechstrecke 14 zwischen dem benachbarten zweiten Kontaktelement 5.2 zur Kontaktierung des zweiten Anschlusselements 7.2 der zweiten Wicklung W4 und dem ersten Kontaktelement 6.1 zur Kontaktierung des ersten Anschlusselements 8.1 der ersten Wicklung W3 des Transformators 1 mittels der Aussparung 3 verlängert. Die ausreichende elektrische Isolation ist damit sowohl für die Kriechstrecken 14 der kritischen benachbarten ersten und zweiten Kontaktelemente 5.2, 6.1 als auch die ersten und zweiten Anschlusselemente 7.2, 8.1 sichergestellt.

Die Darstellung in Figur 4 gibt lediglich eine mögliche Anwendung wieder, und die Anzahl der bereitgestellten Versorgungsspannungen ebenso wie die Spannungswerte der Versorgungsspannungen sowie die entsprechenden Anforderungen hinsichtlich Isolation und/oder verschärfe Isolation können in unterschiedlichen Ausführungsbeispielen für die Nutzung der Erfindung variieren.

Die Kombination aus der Ausnehmung 12 des Spulenkörpers 9 und der korrespondierender Aussparung 3 der Leiterplatte 2 in einem Betriebsgerät ermöglicht somit den in Figur 4 gezeichneten Anwendungsfall, in dem eine Vielzahl von Versorgungsspannungen für eine Niederspannungsversorgung 18 auch unter den verschärften Anforderungen der Schutzkleinspannungsanwendungen bereitgestellt werden, ohne die räumlichen Abmessungen des Transformators 1 vergrößern zu müssen.

## Patentansprüche

1. Betriebsgerät umfassend einen auf einer Leiterplatte (2) angeordneten Transformator (1) mit einer ersten Wicklung (W3) und zumindest einer zweiten Wicklung (W4) auf einem Spulenkörper (9),
wobei der Spulenkörper (9) einen Basisabschnitt (13) umfasst, in dem zumindest ein erster elektrischer Anschluss (8.1), der mit der ersten Wicklung (W3) elektrisch verbunden ist, und ein zweiter elektrischer Anschluss (7.2), der mit der zumindest einen zweiten Wicklung (W4) elektrisch verbunden ist, angeordnet sind, wobei der Basisabschnitt (13) zwischen dem ersten elektrischen Anschluss (8.1) und dem zweiten elektrischen Anschluss (7.2) eine Ausnehmung (12) aufweist, und
**dadurch gekennzeichnet,**
**dass** die Leiterplatte (2) eine zu der Ausnehmung (12) des Spulenkörpers (9) korrespondierende Aussparung (3) aufweist, wobei die Ausnehmung und die Aussparung einander gegenüberliegen.

2. Betriebsgerät nach Anspruch 1, **dadurch gekennzeichnet, dass** die Ausnehmung (12) Abmessungen aufweist, die eine minimale Kriechstrecke (14) zwischen dem ersten elektrischen Anschlusselement (8.1) und dem zweiten elektrischen Anschlusselement (7.2) gewährleisten, die größer ist als der kürzeste Abstand zwischen den Anschlusselementen (8.1, 7.2).

3. Betriebsgerät nach Anspruch 2, **dadurch gekennzeichnet, dass** eine Ausdehnung der Ausnehmung (12) in einer Richtung senkrecht zu einer Verbindungslinie (19) zwischen dem ersten elektrischen Anschlusselement (8.1) und dem zweiten elektrischen Anschlusselement (7.2) und gemessen ab der Verbindungslinie (19) größer als eine Abmessung der Ausnehmung (12) in Richtung der Verbindungslinie (19) ist.

4. Betriebsgerät nach einem der Ansprüche 1 bis 3, **dadurch gekennzeichnet, dass** der Transformator eine erste sekundärseitige Wicklung als erste Wicklung (W3) eine zweite sekundärseitige Wicklung als zweite Wicklung (W4) und zumindest eine dritte sekundärseitige Wicklung (W2) aufweist.

5. Betriebsgerät nach Anspruch 4, **dadurch gekennzeichnet, dass** die Ausnehmung ausgelegt ist, mittels einer Verlängerung zumindest einer Kriechstrecke (14) zwischen Wicklungen mit hohen Spannungswerten und sekundärseitigen Wicklungen (W2, W3, W4) die Anforderung zur Erzeugung einer Sicherheitskleinspannung erfüllen.

6. Betriebsgerät, umfassend einen Transformator (1) nach Anspruch 4 oder 5 angeordnet auf einer Leiterplatte (2),
wobei die erste sekundärseitige Wicklung (W3) für die Erzeugung einer ersten Versorgungsspannung, die zweite sekundärseitige Wicklung für die Erzeugung einer zweiten Versorgungsspannung und die dritte sekundärseitige Wicklung für die Erzeugung einer dritten Versorgungsspannung genutzt wird.

7. Betriebsgerät nach einem der Ansprüche 1 bis 6, **dadurch gekennzeichnet, dass** der Transformator (1) unmittelbar an einem Rand der Leiterplatte (2) auf der Leiterplatte (2) angeordnet ist.

8. Betriebsgerät nach einem der Ansprüche 1 bis 7, **dadurch gekennzeichnet, dass** die Aussparung (3) der Leiterplatte (2) an einem Umfang der Leiterplatte (2) angeordnet und zu einem Rand der Leiterplatte (2) hin offen ist.

## Claims

1. Operating device comprising a transformer (1) arranged on a circuit board (2) and having a first winding (W3) and at least one second winding (W4) on a coil body (9),
wherein the coil body (9) comprises a base section (13) in which at least one first electrical connection (8.1), which is electrically connected to the first winding (W3), and one second electrical connection (7.2), which is electrically connected to the at least one second winding (W4), are arranged, the base section (13) having a recess (12) between the first electrical connection (8.1) and the second electrical connection (7.2), and
**characterized in that**
the circuit board (2) has a cutout (3) corresponding to the recess (12) of the coil body (9), the recess and the cutout being opposite one another.

2. Operating device according to Claim 1, **characterized in that** the recess (12) has dimensions which ensure a minimum creepage distance (14) between the first electrical connection element (8.1) and the second electrical connection element (7.2), the minimum creepage path being greater than the shortest distance between the connection elements (8.1, 7.2).

3. Operating device according to Claim 2, **characterized in that** an extension of the recess (12) in a direction perpendicular to a connecting line (19) between the first electrical connection element (8.1) and the second electrical connection element (7.2) and measured from the connecting line (19) is greater than a dimension of the recess (12) in the direction of the connecting line (19).

4. Operating device according to any one of Claims 1 to 3,
**characterized in that** the transformer has a first secondary-side winding as the first winding (W3), a second secondary-side winding as the second winding (W4), and at least one third secondary-side winding (W2).

5. Operating device according to Claim 4, **characterized in that** the recess is designed to meet the requirement for generating a protective extra-low voltage by means of an elongation of at least one creepage path (14) between windings with high voltage values and secondary-side windings (W2, W3, W4).

6. Operating device comprising a transformer (1) according to Claims 4 or 5, arranged on a circuit board (2),
wherein the first secondary-side winding (W3) is used for generating a first supply voltage, the second secondary-side winding is used for generating a second supply voltage, and the third secondary-side winding is used for generating a third supply voltage.

7. Operating device according to any one of Claims 1 to 6,
**characterized in that** the transformer (1) is arranged on the circuit board (2) directly at an edge of the circuit board (2).

8. Operating device according to any one of Claims 1 to 7,
**characterized in that** the cutout (3) of the circuit board (2) is arranged on a periphery of the circuit board (2) and is open toward an edge of the circuit board (2).

## Revendications

1. Appareil de commande comprenant un transformateur (1) disposé sur une plaquette de circuit imprimé (2) et comportant un premier enroulement (W3) et au moins un deuxième enroulement (W4) sur un corps de bobine (9),
dans lequel le corps de bobine (9) comprend une section de base (13) dans laquelle sont disposés au moins un premier raccordement (8.1) électrique relié électriquement au premier enroulement (W3) et un second raccordement (7.2) électrique relié électriquement à l'au moins un deuxième enroulement (W4), la section de base (13) présentant un évidement (12) entre le premier raccordement (8.1) électrique et le second raccordement (7.2) électrique, et
**caractérisé en ce**
**que** la plaquette de circuit imprimé (2) présente un creux (3) correspondant à l'évidement (12) du corps de bobine (9), l'évidement et le creux étant opposés l'un à l'autre.

2. Appareil de commande selon la revendication 1, **caractérisé en ce que** l'évidement (12) présente des dimensions qui garantissent une ligne de fuite (14) minimale entre le premier élément de raccordement (8.1) électrique et le second élément de raccordement (7.2) électrique, laquelle ligne de fuite est supérieure à la distance la plus courte entre les éléments de raccordement (8.1, 7.2).

3. Appareil de commande selon la revendication 2, **caractérisé en ce qu'**une extension de l'évidement (12) dans une direction perpendiculaire à une ligne de liaison (19) entre le premier élément de raccordement (8.1) électrique et le second élément de raccordement (7.2) électrique et mesurée à partir de la ligne de liaison (19) est supérieure à une dimension de l'évidement (12) en direction de la ligne de liaison (19).

4. Appareil de commande selon l'une des revendications 1 à 3, **caractérisé en ce que** le transformateur présente un premier enroulement côté secondaire en tant que premier enroulement (W3), un deuxième enroulement côté secondaire en tant que deuxième enroulement (W4), et au moins un troisième enroulement côté secondaire (W2).

5. Appareil de commande selon la revendication 4, **caractérisé en ce que** l'évidement est conçu pour satisfaire à l'exigence pour la production d'une très basse tension de sécurité au moyen d'un prolongement d'au moins une ligne de fuite (14) entre des enroulements comportant des valeurs de tension élevées et des enroulements côté secondaire (W2, W3, W4).

6. Appareil de commande, comprenant un transformateur (1) selon la revendication 4 ou 5 disposé sur une plaquette de circuit imprimé (2),
dans lequel le premier enroulement côté secondaire (W3) est utilisé pour la production d'une première tension d'alimentation, le deuxième enroulement côté secondaire est utilisé pour la production d'une deuxième tension d'alimentation et le troisième enroulement côté secondaire est utilisé pour la production d'une troisième tension d'alimentation.

7. Appareil de commande selon l'une des revendications 1 à 6, **caractérisé en ce que** le transformateur (1) est disposé directement sur un bord de la plaquette de circuit imprimé (2) sur la plaquette de circuit imprimé (2).

8. Appareil de commande selon l'une des revendications 1 à 7, **caractérisé en ce que** le creux (3) de la plaquette de circuit imprimé (2) est disposé sur une circonférence de la plaquette de circuit imprimé (2) et est ouvert vers un bord de la plaquette de circuit imprimé (2).
